(19) Europäisches Patentamt
European Patent Office
Office européen des brevets

(11) **EP 3 443 366 B1**

(12) **FASCICULE DE BREVET EUROPEEN**

(45) Date de publication et mention de la délivrance du brevet:
**12.08.2020 Bulletin 2020/33**

(21) Numéro de dépôt: **17716525.5**

(22) Date de dépôt: **07.04.2017**

(51) Int Cl.:
***G01R 35/04*** *(2006.01)*

(86) Numéro de dépôt international:
**PCT/EP2017/058458**

(87) Numéro de publication internationale:
**WO 2017/178388 (19.10.2017 Gazette 2017/42)**

(54) **PROCÉDÉ DE DÉTECTION D'UN DÉFAUT DANS UN COMPTEUR D'ÉNERGIE ÉLECTRIQUE COMPORTANT UN ORGANE DE COUPURE**

VERFAHREN ZUR FEHLERERKENNUNG BEI EINEM STROMZÄHLER MIT EINER UNTERBRECHUNGSEINHEIT

METHOD FOR DETECTING A FAULT IN AN ELECTRICITY METER INCLUDING A BREAKING UNIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.04.2016 FR 1653232**

(43) Date de publication de la demande:
**20.02.2019 Bulletin 2019/08**

(73) Titulaire: **Sagemcom Energy & Telecom SAS 92500 Rueil-Malmaison (FR)**

(72) Inventeurs:
• TEBOULLE, Henri
  92500 Rueil Malmaison (FR)
• GRINCOURT, Christophe
  92500 Rueil Malmaison (FR)

(74) Mandataire: **Lavaud, Thomas et al Cabinet Boettcher 16, rue Médéric 75017 Paris (FR)**

(56) Documents cités:
US-A1- 2014 327 449    US-A1- 2015 070 507
US-A1- 2015 233 731    US-A1- 2015 377 949

**Description**

L'invention concerne le domaine des compteurs d'énergie électrique.

ARRIERE PLAN DE L'INVENTION

Les compteurs d'énergie électrique modernes sont des compteurs électroniques dits « intelligents » qui sont bien sûr adaptés à mesurer une quantité d'énergie électrique fournie par un distributeur à une installation électrique via un réseau de distribution, mais qui sont aussi capables de réaliser un certain nombre de fonctions complémentaires : gestion des tarifs par réception d'ordres, relève et programmation à distance, télé-information client, etc.

Ces compteurs d'énergie électrique comportent parfois un organe de coupure qui est monté sur un conducteur de phase et qui permet de sélectivement connecter et déconnecter, à distance, l'installation électrique du réseau de distribution.

Le courant électrique circulant dans l'organe de coupure d'un tel compteur d'énergie électrique tend naturellement à élever la température à l'intérieur du compteur d'énergie électrique. Cependant, certains défauts survenant dans le compteur d'énergie électrique peuvent conduire à un échauffement anormal de l'organe de coupure et à une élévation anormale de température à l'intérieur du compteur d'énergie électrique. L'élévation anormale de température risque d'endommager le compteur d'énergie électrique, voire même de provoquer un incendie dans l'installation électrique à partir du compteur d'énergie électrique.

Le document WO-A-2010149921 propose de détecter un échauffement anormal de l'organe de coupure pouvant conduire à une telle élévation anormale de température à l'intérieur du compteur d'énergie électrique. Dans ce document, l'échauffement provient d'une augmentation anormale d'une résistance interne de l'organe de coupure, qui résulte d'une dégradation de l'état de surface des pôles de l'organe de coupure. Ce document enseigne d'estimer l'élévation anormale de la résistance interne en mesurant une tension aux bornes de la résistance interne.

On note cependant que la résistance interne d'un organe de coupure est très faible, de l'ordre de $500\mu\Omega$. La résistance interne de l'organe de coupure peut à titre d'exemple doubler en cas de charbonnage, pour atteindre $1m\Omega$. Lorsqu'un courant électrique d'une intensité de 10A traverse l'organe de coupure fermé, la différence de potentiel aux bornes de l'organe de coupure passe de 5mV à 10mV. Il faut donc pouvoir mesurer une différence de potentiel de 5mV, ce qui représente une précision métrologique très fine (la précision nécessaire est de 0,02%, en considérant qu'un capteur de tension utilisé pour cette mesure est aussi destiné à mesurer la tension fournie par le secteur, soit 230V). Cette méthode est par ailleurs extrêmement sensible aux bruits. Le capteur de tension utilisé doit donc être très performant et donc très coûteux.

On note de plus que le document WO-A-2010149921 permet uniquement de détecter une élévation de température provenant d'un défaut de l'organe de coupure, et non d'une autre cause, comme par exemple un problème de connexion d'un câble électrique au compteur d'énergie électrique.

US 2015/377949 A1 divulgue un compteur d'énergie électrique.

OBJET DE L'INVENTION

L'invention a pour objet de détecter un nombre plus important de défauts potentiels susceptibles d'élever anormalement la température à l'intérieur d'un compteur d'énergie électrique, tout en réduisant le coût de la détection.

RESUME DE L'INVENTION

En vue de la réalisation de ce but, on propose un procédé de détection selon la revendication 1.

Le procédé de détection selon l'invention ne nécessite pas, pour détecter un défaut produisant une élévation anormale de température à l'intérieur du compteur d'énergie électrique, d'utiliser un capteur de tension particulièrement performant et donc coûteux. Le coût de la détection est donc réduit.

Le procédé de détection selon l'invention permet de détecter des défauts propres à l'organe de coupure : vieillissement prématuré de l'organe de coupure suite à des microcoupures dues à des phénomènes tels que des vibrations qui ouvrent de manière intempestive l'organe de coupure, risque de dégradation de l'organe de coupure lors d'ouvertures ou de fermetures en cas de charge fortement inductive, phénomène de charbonnage augmentant une résistance interne de l'organe de coupure et provoquant un échauffement plus important de l'organe de coupure pour un même courant électrique le traversant, etc.

Le procédé de détection selon l'invention permet aussi de détecter des défauts extérieurs à l'organe de coupure, et notamment un mauvais serrage de câbles électriques connectés au compteur, qui peut provoquer un échauffement critique à l'intérieur du compteur. Un tel défaut n'est pas détecté par un procédé de détection basé uniquement sur une mesure de résistance de l'organe de coupure (et notamment via une mesure de tension aux bornes de l'organe de coupure).

On propose de plus un compteur d'énergie électrique comportant un organe de coupure, un capteur de courant destiné à mesurer un courant électrique circulant dans l'organe de coupure lorsque celui-ci est fermé, un capteur de température intérieure positionné à proximité de l'organe de coupure, et des moyens de traitement agencés pour mettre en œuvre le procédé de détection selon la revendication 1.

On propose de plus un programme d'ordinateur comprenant des instructions pour mettre en œuvre, par un compteur d'énergie électrique, le procédé de détection selon la revendication 1.

On propose en outre des moyens de stockage, caractérisés en ce qu'ils stockent un programme d'ordinateur comprenant des instructions pour mettre en œuvre, par un compteur d'énergie électrique, le procédé de détection selon la revendication 1.

L'invention sera mieux comprise à la lumière de la description qui suit de modes de mise en œuvre particuliers non limitatifs.

BREVE DESCRIPTION DES DESSINS

Il sera fait référence aux dessins annexés, parmi lesquels :

- la figure 1 est un graphique comportant des courbes d'élévation de température dans un compteur d'énergie électrique, alors que l'intensité du courant électrique circulant dans un organe de coupure du compteur passe d'un premier palier d'une première intensité à un deuxième palier d'une deuxième intensité supérieure à la première intensité ;
- la figure 2 est une figure analogue à la figure 1, dans laquelle la deuxième intensité est inférieure à la première intensité ;
- la figure 3 représente une table comportant des valeurs d'intensité et, pour chaque valeur d'intensité, des seuils d'élévation de température.

DESCRIPTION DETAILLEE

Le procédé de détection selon un premier mode de réalisation est mis en œuvre dans un compteur d'énergie électrique.

Le compteur est destiné à mesurer une énergie électrique qui est fournie par un réseau de distribution situé en amont du compteur et qui est consommée par une installation électrique située en aval du compteur.

La fourniture d'énergie électrique consiste à fournir un courant électrique sous une certaine tension électrique à l'installation électrique. Le courant électrique circule sur un conducteur de phase qui s'étend sur une courte portion au travers du compteur.

Le compteur comporte un organe de coupure qui est monté sur le conducteur de phase à l'intérieur du compteur. L'organe de coupure permet de sélectivement connecter et déconnecter, à distance, l'installation électrique du réseau de distribution. La résistance interne de l'organe de coupure est d'environ $500\mu\Omega$ (ou d'environ $1,5m\Omega$ en tenant compte de barres de cuivre situées de part et d'autre d'un contact mobile de l'organe de coupure).

Outre l'organe de coupure, le compteur comporte un capteur de courant, un capteur de température intérieure et une carte électrique comprenant des moyens de traitement. Les moyens de traitement comprennent un composant de traitement intelligent (par exemple un microcontrôleur, un processeur, un FPGA, etc.) adapté à exécuter des instructions d'un programme pour mettre en œuvre le procédé de détection selon le premier mode de réalisation.

Le capteur de courant est destiné à mesurer le courant électrique circulant dans l'organe de coupure lorsque celui-ci est fermé. Le courant électrique présente une intensité comprise classiquement entre 1A et 65A, tout en pouvant bien sûr être inférieure à 1A et supérieure à 65A. On note que le capteur de courant dont il est question ici est un capteur de courant classique équipant le compteur et destiné à mesurer le courant électrique consommé par l'installation électrique. Le capteur de courant n'est donc pas dédié à la mise en œuvre du procédé de détection selon le premier mode de réalisation.

Le capteur de température intérieure est positionné à proximité de l'organe de coupure (éventuellement au contact de l'organe de coupure) et est destiné à mesurer une température intérieure du compteur, à proximité de l'organe de coupure. Le capteur de température intérieure est lui aussi un capteur de température classique. Le capteur de température intérieure n'est pas, lui non plus, dédié à la mise en œuvre du procédé de détection selon le premier mode de réalisation.

On note que le compteur utilisé ici ne comporte pas de capteur de température extérieure destiné à mesurer une température extérieure du compteur. Le coût de la mise en œuvre du procédé de détection selon le premier mode de réalisation est donc réduit par rapport au coût de la mise en œuvre d'un procédé de détection nécessitant un capteur de température extérieure.

Le procédé de détection selon le premier mode de réalisation, mis en œuvre par les moyens de traitement, permet de détecter un défaut produisant une élévation anormale de température à l'intérieur du compteur d'énergie électrique. Des exemples de tels défauts ont été fournis plus tôt dans la description.

Le procédé de détection selon le premier mode de réalisation consiste à mesurer l'intensité du courant électrique circulant dans l'organe de coupure lorsque l'organe de coupure est fermé, à mesurer la température intérieure, et à détecter la présence ou non du défaut à partir de l'intensité mesurée et de la température intérieure mesurée.

Comme le compteur utilisé ici ne comporte pas de capteur de température extérieure, il est délicat de détecter une élévation anormale de température à l'intérieur du compteur, puisque la température intérieure mesurée par le capteur de température intérieure dépend non seulement d'un échauffement produit par la circulation du courant électrique dans l'organe de coupure (un tel échauffement est inévitable), mais aussi, bien sûr, de la température extérieure.

Le procédé de détection selon le premier mode de réalisation utilise donc un gradient de température intérieure en fonction de l'intensité du courant électrique circulant dans l'organe de coupure.

Les moyens de traitement acquièrent tout d'abord une première température intérieure (mesurée par le capteur de température intérieure) lorsque l'intensité mesurée du courant électrique atteint un premier palier d'une première intensité (mesurée par le capteur de courant), puis acquièrent une deuxième température intérieure (mesurée par le capteur de température intérieure) lorsque l'intensité mesurée atteint un deuxième palier d'une deuxième intensité (mesurée par le capteur de courant). Le deuxième palier est un palier qui succède directement au premier palier.

Les paliers dont il est ici question constituent de manière générale la forme d'une courbe de l'intensité du courant électrique consommé par l'installation électrique. Lorsqu'un ou plusieurs appareils de l'installation électrique fonctionnent, la courbe de l'intensité du courant électrique atteint un palier et se stabilise sur le palier. Lorsqu'un appareil additionnel est activé, la courbe de l'intensité du courant électrique atteint un palier suivant et se stabilise sur le palier suivant.

Chaque palier est défini comme étant une portion d'une courbe de l'intensité du courant électrique, portion sur laquelle l'intensité du courant électrique est stable pendant une durée prédéterminée.

Par « stable », on entend qu'une différence maximum en valeur absolue entre une intensité quelconque d'un palier et l'intensité moyenne du palier est inférieure ou égale à un seuil de palier prédéterminé. Ici, la première intensité est l'intensité moyenne du premier palier et la deuxième intensité est l'intensité moyenne du deuxième palier. Ainsi, une différence maximum en valeur absolue entre une intensité quelconque du premier palier et la première intensité est inférieure ou égale à un premier seuil de palier prédéterminé, et une différence maximum en valeur absolue entre une intensité quelconque du deuxième palier et la deuxième intensité est inférieure ou égale à un deuxième seuil de palier prédéterminé.

Le premier seuil de palier prédéterminé est avantageusement compris entre 5% et 25% de la première intensité et le deuxième seuil de palier prédéterminé est avantageusement compris entre 5% et 25% de la deuxième intensité. Ici, le premier seuil de palier prédéterminé est égal à 15% de la première intensité et le deuxième seuil de palier prédéterminé est égal à 15% de la deuxième intensité (le premier seuil de palier prédéterminé et le deuxième seuil de palier prédéterminé pourraient être différents).

La durée prédéterminée correspond ici à 10min de l'intensité mesurée intégrée sur des périodes non glissantes de 1min.

La première intensité et/ou la deuxième intensité (c'est à dire au moins l'une des deux) doivent être supérieures ou égales à un seuil d'intensité prédéterminé pour que la première intensité et la deuxième intensité soient prises en compte pour mettre en œuvre le procédé de détection selon le premier mode de réalisation.

En effet, si le courant électrique présente une intensité faible, l'échauffement de l'organe de coupure provoqué par un tel courant électrique ne présente aucun risque d'endommagement du compteur ou d'incendie pour l'installation électrique, et le procédé de détection n'est pas mis en œuvre. Ainsi, si ni la première intensité ni la deuxième intensité ne sont supérieures ou égales au seuil d'intensité prédéterminé, la première intensité et la deuxième intensité ne sont pas prises en compte.

On parle ici d'intensité en valeur absolue : on considère en effet que l'intensité du courant électrique circulant dans l'organe de coupure lorsque celui-ci est fermé présente un signe constant représentatif d'un courant électrique circulant pour alimenter l'installation électrique (et non produit par l'installation électrique). Si le signe de l'intensité est négatif (pour répondre à une norme quelconque), on prend en compte la valeur absolue de l'intensité.

Le seuil d'intensité prédéterminé est avantageusement compris entre 1A et 10A. Le seuil d'intensité prédéterminé est ici égal à 5A.

Une différence entre la deuxième intensité et la première intensité doit par ailleurs être supérieure ou égale, en valeur absolue, à un seuil de différence d'intensité prédéterminé. En effet, si la première intensité et la deuxième intensité sont trop proches, la différence d'intensité ne produit pas une différence d'échauffement significative de l'organe de coupure. La première intensité et la deuxième intensité ne permettent alors pas de mettre en œuvre le procédé de détection de manière efficace et ne sont pas prises en compte.

Le seuil de différence d'intensité prédéterminé est avantageusement compris entre 5A et 15A. Le seuil de différence d'intensité prédéterminé est ici égal à 9A.

Le procédé de détection consiste ensuite à acquérir une première température intérieure à proximité de l'organe de coupure lorsque l'intensité mesurée atteint le premier palier de la première intensité et à acquérir une deuxième température intérieure à proximité de l'organe de coupure lorsque l'intensité mesurée atteint le deuxième palier de la deuxième intensité.

Le procédé de détection consiste enfin à détecter la présence ou non d'un défaut à partir du rapport entre, d'une part, une différence entre la deuxième température intérieure et la première température intérieure, et, d'autre part, une différence entre la deuxième intensité et la première intensité.

Un défaut potentiel est détecté lorsque le rapport est supérieur ou égal à un seuil de défaut potentiel prédéterminé. Le seuil de défaut potentiel prédéterminé est avantageusement compris entre 0,2°C/A et 0,8°C/A. Ici, le seuil de défaut potentiel prédéterminé est égal à 0,4°C/A.

Un défaut avéré est détecté lorsque le rapport est supérieur ou égal à un seuil de défaut avéré prédéterminé supérieur au seuil de défaut potentiel. Le seuil de défaut avéré prédéterminé est avantageusement compris entre 0,2°C/A et 0,8°C/A. Ici, le seuil de défaut avéré prédéterminé est égal à 0,6°C/A.

Lorsque les moyens de traitement détectent un défaut potentiel, les moyens de traitement envoient un message d'alerte vers un système informatique du fournisseur d'énergie électrique (ou du gestionnaire du réseau). Le fournisseur d'énergie électrique (ou le gestionnaire du réseau) décide alors éventuellement de commander l'ouverture de l'organe de coupure en envoyant une commande d'ouverture. L'ouverture de l'organe de coupure permet en effet d'annuler l'intensité du courant électrique circulant dans l'organe de coupure et donc de réduire très fortement voire totalement l'échauffement de l'organe de coupure et donc les risques d'incendie.

Le message d'alerte et la commande d'ouverture sont transmis de manière bidirectionnelle via des messages DLMS/COSEM.

Lorsque les moyens de traitement détectent un défaut avéré, les moyens de traitement envoient un message d'alarme vers le système informatique du fournisseur d'énergie électrique (ou du gestionnaire du réseau). Le fournisseur d'énergie électrique (ou le gestionnaire du réseau) décide alors de commander l'ouverture de l'organe de coupure en envoyant une commande d'ouverture. Le message d'alarme et la commande d'ouverture sont transmis de manière bidirectionnelle via des messages DLMS/COSEM.

Un exemple de message d'alarme est présenté ici :

```
<EventNotificationRequest>
<AttributeDescriptor>
<ClassId Value=«0001» />
<InstanceId Value=«0000616200FF» />
<AttributeId Value=«02» />
</AttributeDescriptor>
<AttributeValue>
<DoubleLongUnsigned Value=«00000001» />
</AttributeValue>
</EventNotificationRequest>.
```

L'encodage associé au message d'alarme est : C20000010000616200FF020600000001.

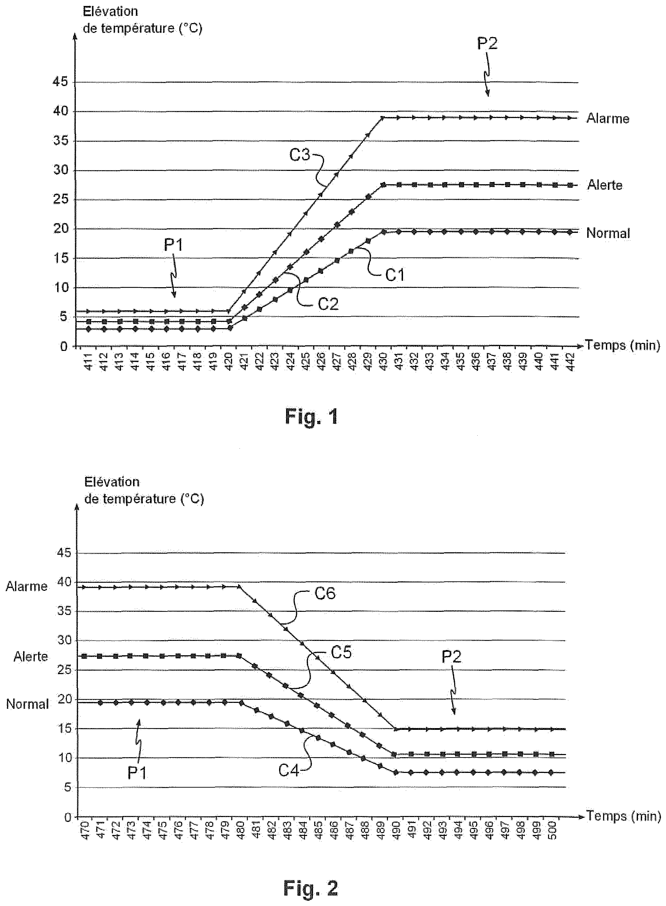

On illustre le procédé de détection selon le premier mode de réalisation en référence à la figure 1.

Une première courbe d'élévation de température C1, une deuxième courbe d'élévation de température C2, et une troisième courbe d'élévation de température C3 sont représentées sur la figure 1.

Ces courbes d'élévation de température correspondent à une situation dans laquelle la première intensité I1 du premier palier P1 est égale à 10A (soit supérieure au seuil d'intensité prédéterminé de 5A), la deuxième intensité I2 du deuxième palier P2 est égale à 65A (soit supérieure au seuil d'intensité prédéterminé de 5A). La deuxième intensité I2 du deuxième palier P2 est donc supérieure à la première intensité I1 du premier palier P1. Une différence entre la deuxième intensité I2 et la première intensité I1 est égale à 55A et est donc supérieure, en valeur absolue, au seuil de différence d'intensité prédéterminé égal à 9A.

Une différence maximum en valeur absolue entre une intensité quelconque du premier palier P1 et la première intensité I1 est inférieure ou égale à 15% de la première intensité I1 (soit inférieure ou égale au premier seuil de palier prédéterminé). Une différence maximum en valeur absolue entre une intensité quelconque du deuxième palier P2 et la deuxième intensité I2 est inférieure ou égale à 15% de la deuxième intensité I2 (soit inférieure ou égale au deuxième seuil de palier prédéterminé).

Le procédé de détection peut donc être mis en œuvre avec le premier palier P1 et le deuxième palier P2 représentés ici.

La première courbe d'élévation de température C1 correspond à un cas où l'élévation de température au niveau du premier palier P1 est égale à 3,0°C et où l'élévation de température au niveau du deuxième palier P2 est égale à 19,5°C. Bien sûr, comme la température extérieure du compteur n'est pas accessible pour les moyens de traitement, les moyens de traitement ne disposent pas en réalité de ces valeurs d'élévation de température. Cependant, comme les variations de la température extérieure sont négligeables au regard de la durée cumulée du premier palier P1, du deuxième palier P2 et de la transition entre le premier palier P1 et le deuxième palier P2, la différence entre la deuxième température intérieure T2 et la première température intérieure T1 est égale à la différence entre l'élévation de température au niveau du deuxième palier P2 et l'élévation de température au niveau du premier palier P1.

Le rapport entre, d'une part, une différence entre la deuxième température intérieure T2 et la première température intérieure T1 (mesurées par le capteur de température intérieure), et, d'autre part, une différence entre la deuxième intensité I2 et la première intensité I1 (mesurées par le capteur de courant) correspond donc à un gradient de température intérieure en fonction de l'intensité du courant électrique, mais aussi, selon ce qui vient d'être dit, à un gradient d'élévation de température dans le compteur en fonction de l'intensité du courant électrique.

Pour la première courbe d'élévation de température C1, le rapport Grad1 entre, d'une part, une différence entre la deuxième température intérieure T2 et la première température intérieure T1, et, d'autre part, une différence entre la deuxième intensité I2 et la première intensité I1, est tel que :

$$\mathrm{Grad1}=(\mathrm{T2-T1})/(\mathrm{I2-I1})=0,30.$$

Le rapport Grad1 est donc inférieur au seuil de défaut potentiel (ici égal à 0,4°C/A), et donc, bien sûr, au seuil de défaut avéré (ici égal à 0,6°C/A) : les moyens de traitement ne détectent aucun défaut.

La deuxième courbe d'élévation de température C2 correspond à un cas où l'élévation de température au niveau du premier palier P1 est égale à 4,2°C et où l'élévation de température au niveau du deuxième palier P2 est égale à 27,3°C.

Pour la deuxième courbe d'élévation de température C2, le rapport Grad2 entre, d'une part, une différence entre la deuxième température intérieure T2 et la première température intérieure T1, et, d'autre part, une différence entre la deuxième intensité I2 et la première intensité I1, est tel que :

$$\mathrm{Grad2}=(\mathrm{T2-T1})/(\mathrm{I2-I1})=0,42.$$

Le rapport Grad2 est donc supérieur au seuil de défaut potentiel prédéterminé (ici égal à 0,4°C/A) et inférieur au seuil de défaut avéré prédéterminé (ici égal à 0,6°C/A) : les moyens de traitement détectent un défaut potentiel. Un message d'alerte est envoyé par les moyens de traitement.

La troisième courbe d'élévation de température C3 correspond à un cas où l'élévation de température au niveau du premier palier P1 est égale à 6,0°C et où l'élévation de température au niveau du deuxième palier P2 est égale à 39,0°C.

Pour la troisième courbe d'élévation de température C3, le rapport Grad3 entre, d'une part, une différence entre la deuxième température intérieure T2 et la première température intérieure T1, et, d'autre part, une différence entre la deuxième intensité I2 et la première intensité I1, est tel que :

$$\mathrm{Grad3}=(\mathrm{T2-T1})/(\mathrm{I2-I1})=0,60.$$

Le rapport Grad3 est donc égal au seuil de défaut avéré prédéterminé (ici égal à 0,6°C/A) : les moyens de traitement détectent un défaut avéré. Un message d'alarme est envoyé par les moyens de traitement.

On illustre maintenant le procédé de détection selon le premier mode de réalisation de l'invention en référence à la figure 2.

Une quatrième courbe d'élévation de température C4, une cinquième courbe d'élévation de température C5, et une sixième courbe d'élévation de température C6 sont représentées sur la figure 2.

Ces courbes d'élévation de température correspondent à une situation dans laquelle la première intensité I1 du premier palier P1 est égale à 65A (soit supérieure au seuil d'intensité prédéterminé de 5A), la deuxième intensité I2 du deuxième palier P2 est égale à 25A (soit supérieure au seuil d'intensité prédéterminé de 5A). La deuxième intensité I2 du deuxième palier P2 est donc inférieure à la première intensité I1 du premier palier P1. Une différence entre la deuxième intensité I2 et la première intensité I1 est égale à -40A et est donc supérieure, en valeur absolue, au seuil de différence d'intensité prédéterminé égal à 9A.

Une différence maximum en valeur absolue entre une intensité quelconque du premier palier P1 et la première intensité I1 est inférieure ou égale à 15% de la première intensité I1 (soit inférieure ou égale au premier seuil de palier prédéterminé). Une différence maximum en valeur absolue entre une intensité quelconque du deuxième palier P2 et la deuxième intensité I2 est inférieure ou égale à 15% de la deuxième intensité I2 (soit inférieure ou égale au deuxième seuil de palier prédéterminé).

Le procédé de détection peut donc être mis en œuvre avec le premier palier P1 et le deuxième palier P2 représentés ici.

La quatrième courbe d'élévation de température C4 correspond à un cas où l'élévation de température au niveau du premier palier P1 est égale à 19,5°C et où l'élévation de température au niveau du deuxième palier P2 est égale à 7,5°C.

Pour la quatrième courbe d'élévation de température C4, le rapport Grad4 entre, d'une part, une différence entre la deuxième température intérieure T2 et la première température intérieure T1, et, d'autre part, une différence entre la deuxième intensité I2 et la première intensité I1, est tel que :

$$Grad4=(T2-T1)/(I2-I1)=0,30.$$

Le rapport Grad4 est donc inférieur au seuil de défaut potentiel prédéterminé (ici égal à 0,4°C/A), et donc, bien sûr, au seuil de défaut avéré prédéterminé (ici égal à 0,6°C/A) : les moyens de traitement ne détectent aucun défaut.

La cinquième courbe d'élévation de température C5 correspond à un cas où l'élévation de température au niveau du premier palier P1 est égale à 27,3°C et où l'élévation de température au niveau du deuxième palier P2 est égale à 10,5°C.

Pour la cinquième courbe d'élévation de température C5, le rapport Grad5 entre, d'une part, une différence entre la deuxième température intérieure T2 et la première température intérieure T1, et, d'autre part, une différence entre la deuxième intensité I2 et la première intensité I1, est tel que :

$$Grad5=(T2-T1)/(I2-I1)=0,42.$$

Le rapport Grad5 est donc supérieur au seuil de défaut potentiel prédéterminé (ici égal à 0,4°C/A) et inférieur au seuil de défaut avéré prédéterminé (ici égal à 0,6°C/A) : les moyens de traitement détectent un défaut potentiel. Un message d'alerte est envoyé par les moyens de traitement.

La sixième courbe d'élévation de température C6 correspond à un cas où l'élévation de température au niveau du premier palier P1 est égale à 39,0°C et où l'élévation de température au niveau du deuxième palier P2 est égale à 15,0°C.

Pour la sixième courbe d'élévation de température C6, le rapport Grad6 entre, d'une part, une différence entre la deuxième température intérieure T2 et la première température intérieure T1, et, d'autre part, une différence entre la deuxième intensité I2 et la première intensité I1, est tel que :

$$Grad3=(T2-T1)/(I2-I1)=0,60.$$

Le rapport Grad2 est donc égal au seuil de défaut avéré prédéterminé (ici égal à 0,6°C/A) : les moyens de traitement détectent un défaut avéré. Un message d'alarme est envoyé par les moyens de traitement.

On note ici que le seuil de défaut potentiel prédéterminé et le seuil de défaut avéré prédéterminé utilisés sont les mêmes lorsque la première intensité est supérieure à la deuxième intensité, et lorsque la deuxième intensité est supérieure à la première intensité.

On note aussi que les rapports Grad1, Grad2 et Grad3 sont égaux respectivement aux rapports Grad4, Grad5 et Grad6, et ce, bien que la deuxième intensité de la figure 2 ne soit pas égale à la première intensité de la figure 1. Les rapports attendus dépendent donc uniquement de la situation de défaut dans le compteur (absence de défaut, défaut potentiel, défaut avéré) et non de l'intensité du courant électrique consommé par l'installation électrique.

Avantageusement, l'intensité mesurée entre le premier palier P1 et le deuxième palier P2 est filtrée par un premier filtre numérique passe-bas si la deuxième intensité I2 est supérieure à la première intensité I1, et par un deuxième filtre numérique passe-bas si la deuxième intensité I2 est inférieure à la première intensité I1.

Le premier filtre numérique passe-bas est un filtre du premier ordre avec une fréquence de coupure fc1 basse, égale ici à $10^{-2}$Hz.

Un exemple d'un tel premier filtre numérique passe-bas du premier ordre est le filtre ayant pour fonction de transfert en Z, en supposant que la fréquence d'échantillonnage est de 0,1Hz :

$$H(Z) = (1 + Z^{-1}) / (1 - a \cdot Z^{-1}).$$

Une sortie numérique $S_n$ de ce filtre par rapport à une entrée numérique $E_n$ de ce filtre est : $S_n = E_n + E_{n-1} + a \cdot S_{n-1}$, avec a=0,5095254495.

Le deuxième filtre numérique passe-bas est un filtre du premier ordre semblable au premier filtre passe-bas, avec une fréquence de coupure fc2 supérieure à fc1 et ici égale à 2*fc1, soit égale ici à $2.10^{-2}$Hz. Dans ce cas, a=0,1583844403.

On retarde ainsi la montée en intensité par rapport à la descente en intensité. On compense des effets d'inertie thermiques qui ont pour conséquence que, pour une différence donnée entre la première intensité I1 et la deuxième intensité I2, la température augmente plus rapidement, lorsque l'intensité augmente entre la première intensité I1 et la deuxième intensité I2, qu'elle ne diminue, lorsque l'intensité diminue entre la première intensité I1 et la deuxième intensité I2.

On prévoit en outre, indépendamment de ce qui vient d'être décrit, d'envoyer un message d'alerte prioritaire lorsque la température intérieure du compteur dépasse un seuil de température d'alerte prioritaire dépendant de l'intensité du courant mesuré, et d'envoyer un message d'alarme prioritaire lorsque la température intérieure dépasse un seuil de température d'alarme prioritaire dépendant de l'intensité du courant mesuré.

Le message d'alerte prioritaire et le message d'alarme prioritaire sont envoyés quoiqu'il arrive et de manière prioritaire par rapport aux critères évoqués plus tôt et relatifs au rapport entre une différence entre la deuxième température et la première température, et entre une différence entre la deuxième intensité et la première intensité.

Le message d'alerte prioritaire et le message d'alarme prioritaire constituent des précautions supplémentaires permettant de commander très rapidement une ouverture de l'organe de coupure lorsque l'échauffement est très important et doit être réduit de manière urgente.

Le procédé de détection selon un deuxième mode de réalisation est mis en œuvre dans un compteur semblable au compteur précédemment décrit mais comportant cette fois, outre le capteur de température intérieure, un capteur de température extérieure qui mesure une température extérieure du compteur.

Le procédé de détection selon le deuxième mode de réalisation consiste tout d'abord, à un moment donné, à mesurer l'intensité du courant électrique circulant dans l'organe de coupure lorsque l'organe de coupure est fermé, à mesurer la température intérieure du compteur, et à mesurer la température extérieure du compteur.

Les moyens de traitement calculent alors une élévation de température égale à une différence entre la température intérieure et la température extérieure.

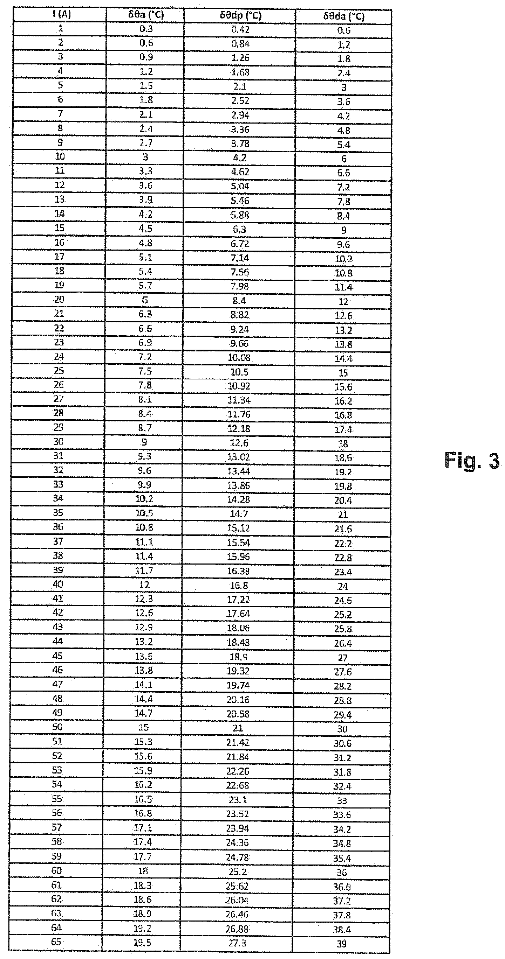

Puis, les moyens de traitement accèdent à une table T, visible sur la figure 3, stockée dans une mémoire des moyens de traitement.

La table T comporte des valeurs d'intensité I(A) (de 1A à 65A avec un pas de 1A) et, pour chaque valeur d'intensité I(A), une élévation de température attendue $\delta\theta a$, un seuil d'élévation de température représentatif d'un défaut potentiel $\delta\theta dp$, et un seuil d'élévation de température représentatif d'un défaut avéré $\delta\theta da$. L'élévation de température attendue $\delta\theta a$, le seuil d'élévation de température représentatif d'un défaut potentiel $\delta\theta dp$, et le seuil d'élévation de température représentatif d'un défaut avéré $\delta\theta da$ sont des valeurs prédéterminées qui dépendent de la valeur d'intensité I(A) à laquelle elles sont associées.

Les moyens de traitement comparent l'élévation de température calculée actuelle avec l'élévation de température attendue $\delta\theta a$, le seuil d'élévation de température représentatif d'un défaut potentiel $\delta\theta dp$, et le seuil d'élévation de température représentatif d'un défaut avéré $\delta\theta da$ de la table T associés à l'intensité mesurée, et détectent alors soit une absence de défaut, soit un défaut potentiel, soit un défaut avéré.

Par exemple, si le capteur de courant mesure une intensité de 28A, et que l'élévation de température est proche de 8,4°C (c'est à dire de la valeur $\delta\theta a$ pour la valeur d'intensité I(A)=28A dans la table T), les moyens de traitement ne détectent aucun défaut. Si l'élévation de température est supérieure ou égale à 11,76°C (c'est à dire à la valeur $\delta\theta dp$ pour la valeur d'intensité I(A)=28A dans la table T), les moyens de traitement détectent un défaut potentiel, et envoient un message d'alerte. Si l'élévation de température est supérieure ou égale à 16,8°C (c'est à dire à la valeur $\delta\theta da$ pour la valeur d'intensité I(A)=28A dans la table T), les moyens de traitement détectent un défaut avéré, et envoient un message d'alarme.

Bien entendu, l'invention n'est pas limitée aux modes de réalisation décrits mais englobe toute variante entrant dans le champ de l'invention telle que définie par les revendications.

Bien que l'on ait, dans le procédé de détection selon le premier mode de réalisation, utilisé un seuil de défaut potentiel prédéterminé et un seuil de défaut avéré prédéterminé, il aurait parfaitement été possible d'utiliser un unique seuil de défaut prédéterminé (lui aussi avantageusement compris entre 0,2°C/A et 0,8°C/A), et de détecter un défaut lorsque le rapport entre les températures et les intensités est supérieur ou égal au seuil de défaut prédéterminé.

De même, bien que l'on ait, dans le procédé de détection selon le deuxième mode de réalisation de l'invention, utilisé un seuil d'élévation de température représentatif d'un défaut potentiel et un seuil d'élévation de température représentatif d'un défaut avéré, il aurait été possible d'utiliser un unique seuil d'élévation de température prédéterminé qui dépend de l'intensité mesurée, et de détecter un défaut lorsque l'élévation de température est supérieure à ce seuil d'élévation de température prédéterminé.

On a indiqué ici que c'est le fournisseur d'énergie électrique (ou le gestionnaire du réseau) qui commande l'ouverture de l'organe de coupure à la réception d'un message d'alerte ou d'un message d'alarme. Il est cependant possible de prévoir que le compteur lui-même décide de commander l'ouverture de l'organe de coupure en fonction de l'intensité du courant électrique et des températures mesurées. Dans ce cas, on peut prévoir soit que le compteur fonctionne de manière autonome pour prendre la décision de commander l'ouverture de l'organe de coupure, soit que le compteur soit obligé d'envoyer une requête et de recevoir une autorisation (du fournisseur d'énergie électrique ou du gestionnaire du réseau) pour commander l'ouverture de l'organe de coupure, soit que le compteur ait été préprogrammé (par le fournisseur d'énergie électrique ou le gestionnaire de réseau) afin de l'autoriser à ouvrir l'organe de coupure sans envoyer de requête.

Enfin, dans le cas d'un compteur polyphasé, le procédé de l'invention s'applique sur chaque phase, et lorsqu'il y a détection d'un défaut sur une des phases, la décision d'ouvrir l'organe de coupure s'applique sur ladite phase.

En variante, on peut aussi décider d'ouvrir les organes de coupure de toutes les phases dès qu'un défaut conduisant à la décision d'ouvrir l'organe de coupure est détecté sur au moins l'une des phases.

## Revendications

1. Procédé de détection d'un défaut dans un compteur d'énergie électrique comportant un organe de coupure, le défaut produisant une élévation anormale de température à l'intérieur du compteur d'énergie électrique, le procédé de détection comprenant les étapes de :

   - mesurer une intensité d'un courant électrique circulant dans l'organe de coupure ;
   - mesurer une température intérieure du compteur d'énergie électrique, à proximité de l'organe de coupure ;
   - acquérir une première température intérieure du compteur d'énergie électrique, à proximité de l'organe de coupure, lorsque l'intensité mesurée atteint un premier palier (P1) d'une première intensité ;
   - acquérir une deuxième température intérieure du compteur d'énergie électrique, à proximité de l'organe de coupure, lorsque l'intensité mesurée atteint un deuxième palier (P2) d'une deuxième intensité ;
   - détecter la présence ou non du défaut à partir du rapport entre, d'une part, une différence entre la deuxième température et la première température et, d'autre part, une différence entre la deuxième intensité et la première intensité.

2. Procédé de détection selon la revendication 1, dans lequel une différence entre la deuxième intensité et la première intensité doit être supérieure ou égale en valeur absolue à un seuil de différence d'intensité prédéterminé pour que la première intensité et la deuxième intensité soient prises en compte pour mettre en œuvre le procédé de détection.

3. Procédé de détection selon la revendication 2, dans lequel le seuil de différence d'intensité prédéterminé est compris entre 5A et 15A.

4. Procédé de détection selon la revendication 1, dans lequel la première intensité et/ou la deuxième intensité doit être supérieure ou égale à un seuil d'intensité prédéterminé pour que la première intensité et la deuxième intensité soient prises en compte pour mettre en œuvre le procédé de détection.

5. Procédé de détection selon la revendication 4, dans lequel le seuil d'intensité prédéterminé est compris entre 1A et 10A.

6. Procédé de détection selon la revendication 1, dans lequel une différence maximum en valeur absolue entre une intensité quelconque du premier palier et la première intensité doit être inférieure ou égale à un premier seuil de palier prédéterminé, et une différence maximum en valeur absolue entre une intensité quelconque du deuxième palier et la deuxième intensité doit être inférieure ou égale à un deuxième seuil de palier prédéterminé, pour que le premier palier et le deuxième palier soient pris en compte pour mettre en œuvre le procédé de détection.

7. Procédé de détection selon la revendication 6, dans lequel le premier seuil de palier prédéterminé est compris entre 5% et 25% de la première intensité et le deuxième seuil de palier prédéterminé est compris entre 5% et 25% de la deuxième intensité.

8. Procédé de détection selon la revendication 1, dans lequel un défaut est détecté lorsque le rapport est supérieur ou égal à un seuil de défaut prédéterminé.

9. Procédé de détection selon la revendication 8, dans lequel le seuil de défaut prédéterminé est compris entre 0,2°C/A et 0,8°C/A.

10. Procédé de détection selon la revendication 1, dans lequel un défaut potentiel est détecté lorsque le rapport est supérieur ou égal à un seuil de défaut potentiel, et dans lequel un défaut avéré est détecté lorsque le rapport est supérieur ou égal à un seuil de défaut avéré.

11. Procédé de détection selon la revendication 10, comprenant les étapes de :

- envoyer un message d'alerte lorsqu'un défaut potentiel est détecté ;
- envoyer un message d'alarme lorsqu'un défaut avéré est détecté.

12. Procédé de détection selon la revendication 1, dans lequel une ouverture de l'organe de coupure est commandée lorsqu'un défaut est détecté.

13. Procédé de détection selon la revendication 1, comprenant une étape consistant à filtrer l'intensité mesurée entre le premier palier et le deuxième palier, un premier filtre passe-bas présentant une première fréquence de coupure étant utilisé si la deuxième intensité est supérieure à la première intensité, et un deuxième filtre passe-bas présentant une deuxième fréquence de coupure supérieure à la première fréquence de coupure étant utilisé si la deuxième intensité est inférieure à la première intensité.

14. Procédé de détection selon la revendication 1, comprenant en outre les étapes de :

- mesurer une température extérieure du compteur d'énergie électrique ;
- calculer une élévation de température égale à une différence entre la température intérieure et la température extérieure ;
- détecter un défaut lorsque l'élévation de température est supérieure à un seuil d'élévation de température prédéterminé qui dépend de l'intensité mesurée.

15. Procédé de détection selon la revendication 14, comprenant en outre l'étape de stocker dans une mémoire du compteur électrique une table comportant des valeurs d'intensité et, pour chaque valeur d'intensité, une valeur d'élévation de température attendue et le seuil d'élévation de température prédéterminé.

16. Procédé de détection selon la revendication 15, dans lequel la table comporte, pour chaque valeur d'intensité, une valeur d'élévation de température attendue, un seuil d'élévation de température représentatif d'un défaut potentiel et un seuil d'élévation de température représentatif d'un défaut avéré.

17. Procédé de détection selon la revendication 16, comprenant les étapes de :

- envoyer un message d'alerte lorsqu'un défaut potentiel est détecté ;
- envoyer un message d'alarme lorsqu'un défaut avéré est détecté.

18. Compteur d'énergie électrique comportant un organe de coupure, un capteur de courant destiné à mesurer un courant électrique circulant dans l'organe de coupure lorsque celui-ci est fermé, un capteur de température intérieure positionné à proximité de l'organe de coupure, et des moyens de traitement agencés pour mettre en œuvre le procédé de détection selon l'une des revendications précédentes.

19. Programme d'ordinateur comprenant des instructions pour mettre en œuvre, par un compteur d'énergie électrique, le procédé de détection selon l'une des revendications 1 à 17.

20. Moyens de stockage, stockant un programme d'ordinateur comprenant des instructions pour mettre en œuvre, par un compteur d'énergie électrique, le procédé de détection selon l'une des revendications 1 à 17.

**Patentansprüche**

1. Verfahren zur Erkennung eines Fehlers in einem Stromzähler, umfassend ein Unterbrechungsorgan, wobei der Fehler einen anormalen Temperaturanstieg im Inneren des Stromzählers erzeugt, wobei das Erkennungsverfahren die Schritte umfasst:

   - Messen einer Stärke eines Stroms, der in dem Unterbrechungsorgan fließt;
   - Messen einer Innentemperatur des Stromzählers nahe dem Unterbrechungsorgan;
   - Erfassen einer ersten Innentemperatur des Stromzählers nahe dem Unterbrechungsorgan, wenn die gemessene Stärke eine erste Stufe (P1) einer ersten Stärke erreicht;
   - Erfassen einer zweiten Innentemperatur des Stromzählers nahe dem Unterbrechungsorgan, wenn die gemessene Stärke eine zweite Stufe (P2) einer zweiten Stärke erreicht;
   - Erkennen des Vorhandenseins oder Nichtvorhandenseins des Fehlers anhand des Verhältnisses zwischen einerseits einer Differenz zwischen der zweiten Temperatur und der ersten Temperatur und andererseits einer Differenz zwischen der zweiten Stärke und der ersten Stärke.

2. Verfahren zur Erkennung nach Anspruch 1, bei dem eine Differenz zwischen der zweiten Stärke und der ersten Stärke im absoluten Wert größer oder gleich einem vorbestimmten Stärkendifferenzschwellenwert sein muss, damit die erste Stärke und die zweite Stärke berücksichtigt werden, um das Erkennungsverfahren durchzuführen.

3. Verfahren zur Erkennung nach Anspruch 2, bei dem der vorbestimmte Stärkendifferenzschwellenwert zwischen 5A und 15A beträgt.

4. Verfahren zur Erkennung nach Anspruch 1, bei dem die erste Stärke und/oder die zweite Stärke größer oder gleich einem vorbestimmten Stärkenschwellenwert sein muss, damit die erste Stärke und die zweite Stärke berücksichtigt werden, um das Erkennungsverfahren durchzuführen.

5. Verfahren zur Erkennung nach Anspruch 4, bei dem der vorbestimmte Stärkenschwellenwert zwischen 1A und 10A beträgt.

6. Verfahren zur Erkennung nach Anspruch 1, bei dem eine maximale Differenz im absoluten Wert zwischen einer beliebigen Stärke der ersten Stufe und der ersten Stärke kleiner oder gleich einem ersten vorbestimmten Stufenschwellenwert sein muss, und eine maximale Differenz im absoluten Wert zwischen einer beliebigen Stärke der zweiten Stufe und der zweiten Stärke kleiner oder gleich einem zweiten vorbestimmten Stufenschwellenwert sein muss, damit die erste Stufe und die zweite Stufe berücksichtig werden, um das Erkennungsverfahren durchzuführen.

7. Verfahren zur Erkennung nach Anspruch 6, bei dem der erste vorbestimmte Stufenschwellenwert zwischen 5% und 25% der ersten Stärke beträgt und der zweite vorbestimmte Stufenschwellenwert zwischen 5% und 25% der zweiten Stärke beträgt.

8. Verfahren zur Erkennung nach Anspruch 1, bei dem ein Fehler erkannt wird, wenn das Verhältnis größer oder gleich einem vorbestimmten Fehlerschwellenwert ist.

9. Verfahren zur Erkennung nach Anspruch 8, bei dem der vorbestimmte Fehlerschwellenwert zwischen 0,2°C/A und 0,8°C/A beträgt.

10. Verfahren zur Erkennung nach Anspruch 1, bei dem ein möglicher Fehler erkannt wird, wenn das Verhältnis größer oder gleich einem Schwellenwert für einen möglichen Fehler ist, und bei dem ein erwiesener Fehler erkannt wird, wenn das Verhältnis größer oder gleich einem Schwellenwert für einen erwiesenen Fehler ist.

11. Verfahren zur Erkennung nach Anspruch 10, umfassend die Schritte:

   - Senden einer Warnmeldung, wenn ein möglicher Fehler erkannt wird;
   - Senden einer Warnmeldung, wenn ein erwiesener Fehler erkannt wird.

12. Verfahren zur Erkennung nach Anspruch 1, bei dem ein Öffnen des Unterbrechungsorgans gesteuert wird, wenn ein Fehler erkannt wird.

**13.** Verfahren zur Erkennung nach Anspruch 1, umfassend einen Schritt, der darin besteht, die gemessene Stärke zwischen der ersten Stufe und der zweiten Stufe zu filtern, wobei ein erster Tiefpassfilter, der eine erste Grenzfrequenz aufweist, verwendet wird, wenn die zweite Stärke größer als die erste Stärke ist, und ein zweiter Tiefpassfilter, der eine zweite Grenzfrequenz aufweist, die größer als die erste Grenzfrequenz ist, verwendet wird, wenn die zweite Stärke kleiner als die erste Stärke ist.

**14.** Verfahren zur Erkennung nach Anspruch 1, ferner umfassend die Schritte:

- Messen einer Außentemperatur des Stromzählers;
- Berechnen eines Temperaturanstiegs, der gleich einer Differenz zwischen der Innentemperatur und Außentemperatur ist;
- Erkennen eines Fehlers, wenn der Temperaturanstieg größer als ein vorbestimmter Temperaturanstiegsschwellenwert ist, der von der gemessenen Stärke abhängt.

**15.** Verfahren zur Erkennung nach Anspruch 14, ferner umfassend den Schritt des Speicherns einer Tabelle in einem Speicher des Stromzählers, wobei die Tabelle Werte für die Stärke und für jeden Stärkenwert einen erwarteten Temperaturanstiegswert und den vorbestimmten Temperaturanstiegsschwellenwert umfasst.

**16.** Verfahren zur Erkennung nach Anspruch 15, bei dem die Tabelle für jeden Stärkenwert einen erwarteten Temperaturanstiegswert, einen Temperaturanstiegsschwellenwert, der repräsentativ für einen möglichen Fehler ist, und einen Temperaturanstiegsschwellenwert, der repräsentativ für einen erwiesenen Fehler ist, umfasst.

**17.** Verfahren zur Erkennung nach Anspruch 16, umfassend die Schritte:

- Senden einer Warnmeldung, wenn ein möglicher Fehler erkannt wird;
- Senden einer Warnmeldung, wenn ein erwiesener Fehler erkannt wird.

**18.** Stromzähler, umfassend ein Unterbrechungsorgan, einen Stromsensor, der dazu bestimmt ist, einen Strom zu messen, der in dem Unterbrechungsorgan fließt, wenn dieses geschlossen ist, ein Innentemperatursensor, der nahe dem Unterbrechungsorgan positioniert ist, und Verarbeitungsmittel, die ausgebildet sind, um das Verfahren zur Erkennung nach einem der vorhergehenden Ansprüche durchzuführen.

**19.** Computerprogramm, umfassend Anweisungen zum Durchführen des Verfahrens zur Erkennung nach einem der Ansprüche 1 bis 17 mittels eines Stromzählers.

**20.** Speichermittel, die ein Computerprogramm speichern, das Anweisungen zum Durchführen des Verfahrens zur Erkennung nach einem der Ansprüche 1 bis 17 mittels eines Stromzählers umfasst.

**Claims**

**1.** A detection method for detecting a fault in an electricity meter that includes a cutoff member, the fault producing an abnormal rise of temperature inside the electricity meter, the detection method comprising the steps of:

- measuring the magnitude of an electric current flowing through the cutoff member;
- measuring an inside temperature of the electricity meter in the proximity of the cutoff member;
- acquiring a first inside temperature, inside the electricity meter in the proximity of the cutoff member, when the measured current is at a first plateau (P1) at a first current;
- acquiring a second inside temperature, inside the electricity meter in the proximity of the cutoff member, when the measured current is at a second plateau (P2) at a second current; and
- detecting the presence or the absence of a fault on the basis of the ratio of the difference between the second temperature and the first temperature divided by the difference between the second current and the first current.

**2.** A detection method according to claim 1, wherein the difference between the second current and the first current needs to be greater than or equal in absolute value to a predetermined current difference threshold in order for the first current and the second current to be taken into account for performing the detection method.

**3.** A detection method according to claim 2, wherein the predetermined current difference threshold lies in the range 5 A to 15 A.

4. A detection method according to claim 1, wherein the first current and/or the second current needs to be greater than or equal to a predetermined current threshold for the first current and the second current to be taken into account for performing the method of the invention.

5. A detection method according to claim 4, wherein the predetermined current threshold lies in the range 1 A to 10 A.

6. A detection method according to claim 1, wherein a maximum difference in absolute value between a current at any instant during the first plateau and the first current must be less than or equal to a first predetermined plateau threshold, and the maximum difference in absolute value between a current at any instant during the second plateau and the second current must be less than or equal to a second predetermined plateau threshold, in order for the first plateau and the second plateau to be taken into account for performing the detection method.

7. A detection method according to claim 6, wherein the first predetermined plateau threshold lies in the range 5% to 25% of the first current, and the second predetermined plateau threshold lies in the range 5% to 25% of the second current.

8. A detection method according to claim 1, wherein a fault is detected when the ratio is greater than or equal to a predetermined fault threshold.

9. A detection method according to claim 8, wherein the predetermined fault threshold lies in the range 0.2°C/A to 0.8°C/A.

10. A detection method according to claim 1, wherein a potential fault is detected when the ratio is greater than or equal to a potential fault threshold, and wherein a confirmed fault is detected when the ratio is greater than or equal to a confirmed fault threshold.

11. A detection method according to claim 10, comprising the steps of:

   - sending a warning message when a potential fault is detected; and
   - sending an alarm message when a confirmed fault is detected.

12. A detection method according to claim 1, wherein the cutoff member is caused to open when a fault is detected.

13. A detection method according to claim 1, including a step that consists in filtering the measured current between the first plateau and the second plateau, a first lowpass filter presenting a first cutoff frequency being used if the second current is greater than the first current, and a second lowpass filter presenting a second cutoff frequency greater than the first cutoff frequency being used if the second current is less than the first current.

14. A detection method according to claim 1, further comprising the steps of:

   - measuring the temperature outside the electricity meter;
   - calculating a temperature rise equal to the difference between the inside temperature and the outside temperature; and
   - detecting a fault when the temperature rise is greater than a predetermined temperature rise threshold that depends on the measured current.

15. A detection method according to claim 14, further comprising the step of storing a table in a memory of the electricity meter, the table comprising current values, and for each current value, an expected temperature rise value and a predetermined temperature rise threshold.

16. A detection method according to claim 15, wherein, for each current value, the table comprises an expected temperature rise value, a temperature rise threshold representative of a potential fault, and a temperature rise value representative of a confirmed fault.

17. A detection method according to claim 16, comprising the steps of:

- sending a warning message when a potential fault is detected; and
- sending an alarm message when a confirmed fault is detected.

18. An electricity meter including a cutoff member, a current sensor for measuring an electric current flowing through the cutoff member when it is closed, an inside temperature sensor positioned in the proximity of the cutoff member, and processor means arranged to perform the detection method according to any preceding claim.

19. A computer program comprising instructions enabling an electricity meter to perform the detection method according to any one of claims 1 to 17.

20. Storage means, storing a computer program comprising instructions enabling an electricity meter to perform the detection method according to any one of claims 1 to 17.

**EP 3 443 366 B1**

**Fig. 1**

**Fig. 2**

| I (A) | δθa (°C) | δθdp (°C) | δθda (°C) |
|---|---|---|---|
| 1 | 0.3 | 0.42 | 0.6 |
| 2 | 0.6 | 0.84 | 1.2 |
| 3 | 0.9 | 1.26 | 1.8 |
| 4 | 1.2 | 1.68 | 2.4 |
| 5 | 1.5 | 2.1 | 3 |
| 6 | 1.8 | 2.52 | 3.6 |
| 7 | 2.1 | 2.94 | 4.2 |
| 8 | 2.4 | 3.36 | 4.8 |
| 9 | 2.7 | 3.78 | 5.4 |
| 10 | 3 | 4.2 | 6 |
| 11 | 3.3 | 4.62 | 6.6 |
| 12 | 3.6 | 5.04 | 7.2 |
| 13 | 3.9 | 5.46 | 7.8 |
| 14 | 4.2 | 5.88 | 8.4 |
| 15 | 4.5 | 6.3 | 9 |
| 16 | 4.8 | 6.72 | 9.6 |
| 17 | 5.1 | 7.14 | 10.2 |
| 18 | 5.4 | 7.56 | 10.8 |
| 19 | 5.7 | 7.98 | 11.4 |
| 20 | 6 | 8.4 | 12 |
| 21 | 6.3 | 8.82 | 12.6 |
| 22 | 6.6 | 9.24 | 13.2 |
| 23 | 6.9 | 9.66 | 13.8 |
| 24 | 7.2 | 10.08 | 14.4 |
| 25 | 7.5 | 10.5 | 15 |
| 26 | 7.8 | 10.92 | 15.6 |
| 27 | 8.1 | 11.34 | 16.2 |
| 28 | 8.4 | 11.76 | 16.8 |
| 29 | 8.7 | 12.18 | 17.4 |
| 30 | 9 | 12.6 | 18 |
| 31 | 9.3 | 13.02 | 18.6 |
| 32 | 9.6 | 13.44 | 19.2 |
| 33 | 9.9 | 13.86 | 19.8 |
| 34 | 10.2 | 14.28 | 20.4 |
| 35 | 10.5 | 14.7 | 21 |
| 36 | 10.8 | 15.12 | 21.6 |
| 37 | 11.1 | 15.54 | 22.2 |
| 38 | 11.4 | 15.96 | 22.8 |
| 39 | 11.7 | 16.38 | 23.4 |
| 40 | 12 | 16.8 | 24 |
| 41 | 12.3 | 17.22 | 24.6 |
| 42 | 12.6 | 17.64 | 25.2 |
| 43 | 12.9 | 18.06 | 25.8 |
| 44 | 13.2 | 18.48 | 26.4 |
| 45 | 13.5 | 18.9 | 27 |
| 46 | 13.8 | 19.32 | 27.6 |
| 47 | 14.1 | 19.74 | 28.2 |
| 48 | 14.4 | 20.16 | 28.8 |
| 49 | 14.7 | 20.58 | 29.4 |
| 50 | 15 | 21 | 30 |
| 51 | 15.3 | 21.42 | 30.6 |
| 52 | 15.6 | 21.84 | 31.2 |
| 53 | 15.9 | 22.26 | 31.8 |
| 54 | 16.2 | 22.68 | 32.4 |
| 55 | 16.5 | 23.1 | 33 |
| 56 | 16.8 | 23.52 | 33.6 |
| 57 | 17.1 | 23.94 | 34.2 |
| 58 | 17.4 | 24.36 | 34.8 |
| 59 | 17.7 | 24.78 | 35.4 |
| 60 | 18 | 25.2 | 36 |
| 61 | 18.3 | 25.62 | 36.6 |
| 62 | 18.6 | 26.04 | 37.2 |
| 63 | 18.9 | 26.46 | 37.8 |
| 64 | 19.2 | 26.88 | 38.4 |
| 65 | 19.5 | 27.3 | 39 |

Fig. 3

**EP 3 443 366 B1**

## RÉFÉRENCES CITÉES DANS LA DESCRIPTION

**Documents brevets cités dans la description**

- WO 2010149921 A
- US 2015377949 A1